# FASCICULE DE BREVET EUROPEEN

(11) **EP 1 810 948 B1**
(45) Date de publication et mention de la délivrance du brevet: **18.03.2009**
(21) Numéro de dépôt: 07100805.6
(22) Date de dépôt: 19.01.2007
(51) Int. Cl.: B81C 1/00

(54) **Procede d'elaboration d'un support pour la croissance de nanostructures allongées localisées**
Verfahren zur Erzeugung von Zugspannungsgittern in einem Substrat um Nanostrukturen zu bilden
Process to create an array of stress fields on a substrate for nucleation and growth of nanostructures

(30) Priorité: 23.01.2006 FR 0650235
(43) Date de publication de la demande: 25.07.2007
(73) Titulaire: COMMISSARIAT A L'ENERGIE ATOMIQUE, 75752 Paris Cedex 15 (FR)
(72) Inventeur: Fournel, Frank, 38190, VILLARD-BONNOT (FR); Dijon, Jean, 38800, CHAMPAGNIER (FR); Mur, Pierre, 38920, CROLLES (FR)
(74) Mandataire: Poulin, Gérard

(56) Documents cités:
- WO-A-02/29131
- WO-A-20/04000728
- FR-A1- 2 815 121
- JP-A- 2004 261 630
- US-A- 5 783 477

## Description

### DOMAINE TECHNIQUE

L'invention concerne un procédé qui permet d'élaborer un support comprenant des nanoparticules de catalyseur localisées, sur lesquelles on peut faire croître des nanostructures allongées, du type nanofils, nanotubes, nanofibres ou nanocalbes, qui elles aussi sont localisées de manière précise.

### ÉTAT DE LA TECHNIQUE ANTÉRIEURE

De nos jours, les nanostructures allongées du type nanofils, nanotubes, nanofibres ou nanocalbes, sont d'un grand intérêt technologique, notamment dans le domaine de la biologie avec les biopuces et la détection de séquences ADN, ou dans le domaine de la microélectronique avec la fabrication de capteurs à haute densité ou de transistors à effet de champs.

Il existe de nombreuses méthodes d'élaboration de nanofils verticaux. La majorité de ces méthodes consiste à déposer, sur un substrat, des nanoparticules de catalyseur sur lesquelles on fait croître par la suite les nanostructures. C'est la répartition et la taille de ces nanoparticules de catalyseur qui vont gouverner le diamètre, la position et la densité des nanostructures (voir le document **[1]** référencé à la fin de cette description).

Ces nanoparticules de catalyseurs métalliques sont, en général, obtenues en réalisant le fractionnement d'une couche métallique de catalyseur (voir par exemple le document [2]). Ce fractionnement s'effectue en général grâce à un recuit thermique de la couche métallique de catalyseur. Par exemple, le recuit entre 500 et 600°C d'une couche de nickel de 10 nm d'épaisseur, déposée sur un oxyde de silicium, permet d'obtenir des gouttes de nickel de 60 nm de diamètre en moyenne. L'inconvénient de cette technique est qu'elle ne permet pas de contrôler facilement la position, la densité et le diamètre des nanoparticules de catalyseur car celles-ci apparaissent au hasard sur la surface du substrat et sont de tailles variables. Par ailleurs, la densité et le diamètre des nanoparticules ainsi obtenues sont très fortement corrélés. Il est donc très difficile par cette technique de contrôler précisément la position et de choisir indépendamment la densité et le diamètre des nanostructures obtenues.

Certaines méthodes permettent de localiser et de définir précisément le diamètre des nanoparticules métalliques. On peut par exemple utiliser des techniques qui vont définir une à une les nanoparticules métalliques, comme la lithographie électronique par exemple. Cependant, bien que ces méthodes soient précises, elles sont très longues et onéreuses et sont donc incompatibles avec une production industrielle de nanostructures.

Une autre méthode, décrite dans les documents [3] et [4], permet de localiser des nanoparticules à la surfaces d'un substrat. Cette méthode consiste à utiliser des réseaux de défauts cristallins et/ou de champs de contraintes pour induire des sites de nucléation localisés périodiquement dans le plan du substrat. Ces réseaux de défauts cristallins et/ou de champs de contraintes sont créés en collant deux substrats cristallins l'un avec l'autre, puis en amincissant un des substrats jusqu'à obtenir un film cristallin très mince de quelques nanomètres d'épaisseur et en traitant (par exemple thermiquement ou chimiquement) le film cristallin pour révéler le réseau de défauts cristallins et/ou de champs de contraintes à la surface du film. Si le film est suffisamment mince, le réseau de défauts cristallins et/ou de champs de contraintes se propage à la surface du film lors du traitement et provoque la formation de sites de nucléation spécifiques et périodique à la surface du film. Le réseau de défauts cristallins et/ou de champs de contraintes obtenu dépend des caractéristiques des mailles cristallines du film et du substrat, ainsi que des angles de désorientation introduits au moment du collage. On peut donc en modifiant ces caractéristiques et/ou ces angles obtenir des motifs et des localisations différents des sites de nucléation spécifiques à la surface du film.

Cette méthode permet de choisir la distance entre les sites de nucléation et ainsi de fixer la densité des futures nanostructures. Cette méthode est donc appliquée pour contrôler la densité et la périodicité des nanostructures.

Le problème de cette technique est que le dépôt à haute température du matériau catalyseur sur un substrat ainsi préparé (avec des sites de nucléation privilégiés) induit un dépôt directement localisé au niveau de ces sites. Or il peut être intéressant pour certaines applications de dissocier le moment du dépôt et la localisation des nanoparticules de catalyseur. C'est le cas, par exemple, si l'on souhaite déposer un matériau M après la mise en goutte du catalyseur et que ce dépôt ne peut se faire dans le bâti de dépôt du catalyseur (pour des raisons de compatibilité de gaz par exemple). Effectuer la mise en goutte dans le bâti de dépôt du matériau M permet de limiter la surface de contamination potentielle au moment du changement de bâti.

Un autre exemple de procédé de réalisation de nanostructures localisées présentant le même genre de problème est décrit dans le document [5]. Ici, le dépôt localisé des nanostructures est obtenu par dépôt CVD, PVD, LPCVD, épitaxie liquide, trempage, épitaxie gazeuse ou dépôt plasma.

### EXPOSÉ DE L'INVENTION

Le but de l'invention est d'obtenir un procédé permettant une localisation précise des nanoparticules de catalyseur, ce qui permet d'obtenir également des nanostructures localisées par croissance sur ces nanoparticules, en dissociant le dépôt et la localisation de ces nanoparticules.

Ce but est atteint par un procédé de réalisation d'un support comprenant des nanoparticules pour la croissance de nanostructures, lesdites nanoparticules étant organisées de manière périodique, le procédé étant caractérisé en ce qu'il comporte les étapes suivantes :
- fourniture d'un support comportant au voisinage d'une de ses faces un réseau périodique de défauts cristallins et/ou de champs de contraintes,
- dépôt sur ladite face d'une couche continue d'un premier matériau apte à catalyser la réaction de croissance des nanostructures,
- fractionnement de la couche de premier matériau par traitement thermique de manière à former les nanoparticules de premier matériau.

L'invention consiste donc à déposer sur la face d'un support présentant un réseau périodique de défauts cristallins et/ou de champs de contraintes, une couche continue de matériau catalyseur puis, dans une étape ultérieure, à provoquer la mise en gouttes de cette couche pour former les nanoparticules de catalyseur. Ce procédé permet de dissocier l'étape de dépôt et celle de localisation des nanoparticules. On peut ainsi, par exemple, adapter de façon plus souple la température et la durée du traitement thermique de démouillage.

La présence du réseau de défauts cristallins et/ou de champs de contraintes facilite le démouillage ou fractionnement de la couche de catalyseur et assure une localisation précise des nanoparticules de catalyseur. La densité de ces nanoparticules est donc déterminée par le réseau de défauts cristallins et/ou de champs de contraintes, tandis que le diamètre des nanoparticules dépend lui principalement de la quantité de matériau déposée (c'est-à-dire de l'épaisseur de la couche de catalyseur déposée) et du budget thermique du traitement de fractionnement.

Avantageusement, on choisira la période du réseau de défauts cristallins et/ou de champs de contraintes en fonction de la période naturelle d'auto-organisation qu'auraient eu les nanoparticules sur un substrat ne présentant pas ce réseau de défauts cristallins et/ou de champs de contraintes, avec l'épaisseur de couche continue utilisée avant le fractionnement.

Selon un premier mode de réalisation, l'étape de fourniture du support est obtenue en effectuant les étapes suivantes :
- collage par adhésion moléculaire d'une face d'un premier substrat en matériau cristallin avec une face d'un deuxième substrat en matériau cristallin, de façon à ce que lesdites faces présentent des réseaux cristallins décalés, le collage provoquant la formation d'un réseau de défauts cristallins et/ou de champs de contraintes au voisinage de l'interface de collage,
- amincissement de l'un des substrats jusqu'à obtenir un film mince adhérant à l'autre substrat selon l'interface de collage, l'épaisseur du film mince étant telle que sa face libre révèle la présence du réseau de défauts cristallins et/ou de champs de contraintes.

Selon un deuxième mode de réalisation, l'étape de fourniture du support est obtenue en effectuant les étapes suivantes :
- collage par adhésion moléculaire d'une face d'un premier substrat en matériau cristallin avec une face d'un deuxième substrat en matériau cristallin, de façon que lesdites faces présentent des réseaux cristallins décalés, le collage provoquant la formation d'un réseau de champs de contraintes et/ ou de défauts cristallins au voisinage de l'interface de collage,
- amincissement de l'un des substrats jusqu'à obtenir un film mince adhérant à l'autre substrat selon l'interface de collage, l'épaisseur du film mince étant telle que sa face libre ne révèle pas la présence du réseau de champs de contraintes et/ou de défauts cristallins, l'épaisseur du film mince étant aussi telle que l'étape suivante peut être réalisée,
- traitement du film mince conduisant à ce que sa face libre révèle la présence du réseau de défauts cristallins et/ou de champs de contraintes.

Avantageusement, le traitement du film mince peut comprendre un traitement thermique, une attaque mécanique, une attaque chimique, une attaque électrochimique, une attaque ionique ou une attaque photochimique, seul(e) ou en combinaison.

Selon un troisième mode de réalisation, l'étape de fourniture du support est obtenue par report d'un film mince, présentant un réseau de défauts cristallins et/ou de champs de contraintes au voisinage de sa future face libre, sur un substrat. On peut par exemple utiliser le support obtenu selon l'un ou l'autre des précédents modes de réalisation et coller la face du film mince dudit support avec un substrat. Il suffit ensuite d'éliminer (par exemple par amincissement mécanique ou chimique) une partie du support (en fait, il s'agit d'éliminer le substrat initial composant le support) jusqu'à atteindre le film mince.

Selon un autre mode de réalisation, les modes de réalisation précédents sont complétés. Le procédé de réalisation comprend en outre une étape de gravure sélective de la face libre du film mince par des moyens de gravure préférentielle des défauts cristallins et/ou des champs de contraintes ou des zones situées entre ces défauts et/ou ces champs, de manière à obtenir une topographie de surface périodique sur la face du support. Cette topographie facilite le fractionnement ultérieur de la couche de premier matériau.

Avantageusement, le premier substrat et le deuxième substrat sont en un même matériau cristallin.

Avantageusement, le premier substrat et/ou le deuxième substrat sont en Si, Ge, SiC, GaN, GaAs, InP.

Avantageusement, le premier matériau (catalyseur) comprend au moins un métal choisi parmi Ni, Au, W, Pt.

Le premier matériau (catalyseur) peut ainsi par exemple être un empilement d'au moins deux couches de matériau métallique. Cela permet ainsi d'obtenir par la suite des nanoparticules en alliage lors du fractionnement de la couche de catalyseur.

Avantageusement, le procédé selon l'invention comprend en outre une étape de formation d'une couche intermédiaire en un second matériau sur la face du support. Cela permet ainsi de faciliter le démouillage de la couche de premier matériau (catalyseur) et/ou limiter les problèmes d'interdiffusion entre la couche de premier matériau (catalyseur) et le substrat. De préférence, cette couche intermédiaire est déposée de manière continue sur le support. De même, l'épaisseur de cette couche intermédiaire est telle qu'elle n'empêche pas les champs de contraintes du support de se propager à la surface de ladite couche intermédiaire et/ou laisse subsister une topographie à sa surface. En d'autres termes, l'épaisseur de cette couche intermédiaire est suffisamment fine pour que la couche intermédiaire ne bloque pas les champs de contraintes, c'est-à-dire pour que les champs de contraintes puissent se propager à la surface de cette couche intermédiaire, ou, dans le cas où le support présente une topographie de surface, l'épaisseur de la couche intermédiaire doit être suffisamment fine pour qu'elle ne lisse pas complètement le relief de la topographie de surface du support. Par exemple, si on utilise une couche intermédiaire d'oxyde de silicium, l'épaisseur de cette couche sera comprise typiquement entre 1 et 100 nm au dessus du film du support aminci entre 3 et 50 nm comprenant un réseau de défauts cristallins et/ou de champs de contraintes ou pour un relief de topographie de surface ayant une amplitude comprise entre 2 et 10 nm.

Avantageusement, la couche intermédiaire est discontinue et localisée en fonction du réseau périodique de défauts cristallins et/ou de champs de contraintes.

Avantageusement, la couche intermédiaire comprend un matériau choisi parmi SiO₂, Si₃N₄, Al₂O₃, le diamant, HfO₂ ou un matériau semiconducteur (par exemple Si, Ge...).

Selon un mode de réalisation particulier se rattachant au mode de réalisation comprenant une étape de gravure, le substrat sur lequel le film mince adhère est un empilement comprenant une couche d'un troisième matériau située entre un autre film mince de matériau cristallin et un substrat, la face de collage dudit substrat étant la face libre de cet autre film mince de cet empilement.

Avantageusement, l'empilement est un substrat silicium sur isolant (SSI ou SOI en anglais) comprenant une couche d'isolant entre un film mince de silicium et un substrat de silicium.

Avantageusement, la gravure sélective de la face libre du film mince est réalisée jusqu'à atteindre la couche de troisième matériau de l'empilement.

L'invention concerne également un procédé de réalisation de nanostructures sur des nanoparticules localisées sur une face d'un support. Ce procédé comprend la mise en oeuvre du procédé de réalisation du support tel que décrit précédemment, puis une étape de croissance des nanostructures sur les nanoparticules de premier matériau.

### BRÈVE DESCRIPTION DES DESSINS

L'invention sera mieux comprise et d'autres avantages et particularités apparaîtront à la lecture de la description qui va suivre, donnée à titre d'exemple non limitatif, et accompagnée des dessins annexés parmi lesquels :
- les figures 1A à 1E illustrent les étapes d'un exemple de réalisation de nanostructures selon l'invention,
- les figures 2A à 2C illustrent les étapes d'un autre exemple de réalisation de nanostructures selon l'invention,
- les figures 3A à 3F illustrent les étapes d'un troisième exemple de réalisation de nanostructures selon l'invention.

### EXPOSÉ DÉTAILLÉ DE MODES DE RÉALISATION PARTICULIERS

Nous allons à présent illustrer l'invention en donnant plusieurs exemples de réalisation de supports présentant des nanoparticules de catalyseur ordonnées pour la croissance de nanostructures allongées.

Nous allons tout d'abord réaliser un support présentant des nanoparticules de nickel. Comme support présentant un réseau périodique de champs de contraintes, on utilise un substrat « twisté » en collant deux substrats cristallins de silicium. Les détails de réalisation de ce substrat « twisté » sont décrits dans le document **[2]**. Les faces de deux substrats cristallins, par exemple de silicium, sont collés par adhésion moléculaire, de manière à ce que lesdites faces présentent des réseaux cristallins décalés, le collage provoquant la formation d'un réseau de défauts cristallins et/ou de champs de contraintes au sein d'une zone cristalline au voisinage de l'interface de collage. Ces défauts cristallins et/ou champs de contraintes peuvent être induits par la présence de dislocations au niveau de l'interface de collage. Un des substrats est ensuite aminci jusqu'à obtenir un film mince adhérant à l'autre substrat selon l'interface de collage. Enfin, le film mince est traité de manière à ce que sa face libre révèle la présence du réseau de défauts cristallins et/ou de champs de contraintes présent à l'interface de collage. Le traitement du film mince peut se faire par exemple par gravure chimique et/ou par l'apport d'un budget thermique et/ou par l'introduction d'espèces chimiques dans le film mince.

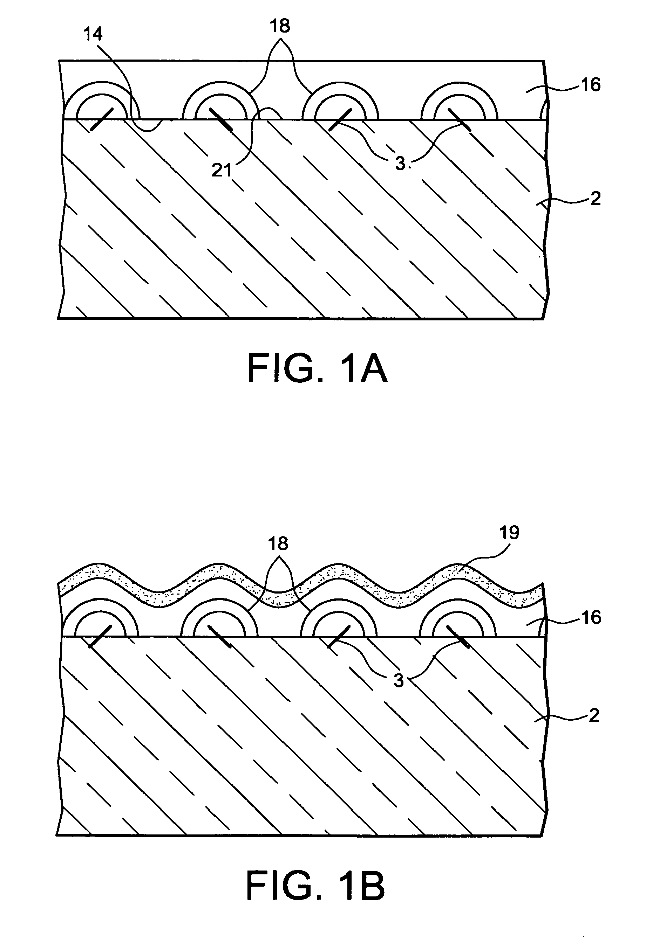

Dans notre exemple, le support est constitué d'un film de silicium (001) sur un substrat de silicium (001) avec un réseau de défauts cristallins et/ou de champs de contraintes à l'interface. Le film et le substrat présentent par exemple une désorientation de 0,88° en rotation sans désorientation de flexion, ce qui engendre un réseau carré de dislocation avec une période de 25 nm. On réalise ensuite un traitement, par exemple une gravure chimique, afin que le réseau de défauts cristallins et/ou de champs de contraintes apparaisse à la surface du film (voir document **[2]**). La figure 1A montre, sous la référence 18, des champs de contraintes. Notons que seuls quelques champs de contraintes ont été représentés. Ces champs de contraintes sont périodiques et la période dépend de la période des réseaux de dislocations 3 présents à l'interface de collage 14/21, c'est-à-dire par exemple à environ 10 nm sous la surface libre du film 16. On peut éventuellement réaliser une gravure le long des champs de contrainte afin de créer un relief de topographie de surface périodique corrélé avec le réseau de champs de contraintes. En utilisant une gravure sensible aux champs de contrainte, on obtient une topographie à la surface du substrat en relation (orientation, périodicité) avec le réseau de champs de contraintes sous-jacent. Cette topographie peut alors être utilisée pour entraîner l'apparition de sites de nucléation localisés et périodiques des nanoparticules de catalyseur.

La gravure peut éventuellement être réalisée jusqu'à faire disparaître les champs de contraintes et le réseau de dislocations au niveau de l'interface de collage.

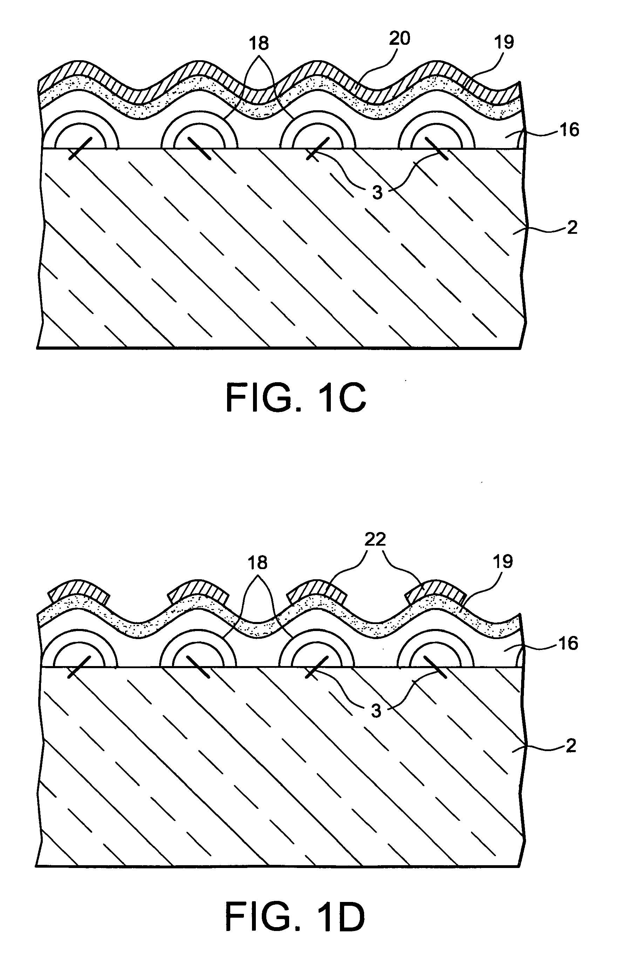

Ensuite, on oxyde la surface du film 16 de silicium pour former une couche intermédiaire 19 d'oxyde (voir figure 1B). Cette couche intermédiaire n'est pas toujours nécessaire, notamment si le fractionnement peut s'opérer directement sur le support (problème d'affinité chimique) ou encore s'il n'y a pas d'interdiffusion majeure entre le matériau du support et le matériau catalyseur. On dépose ensuite, à basse température (par exemple à température ambiante) un film continu 20 de catalyseur, par exemple du nickel sur la couche intermédiaire (voir figure 1C). On porte l'ensemble à plus haute température (par exemple à 550°C) pour que le film 20 de nickel se fractionne. Les gouttes de métal ou nanoparticules 22 sont alors localisées en fonction de l'affinité du métal et de la couche sous-jacente, par exemple dans notre exemple, sur les sommets du relief de la topographie de surface (voir figure 1D). Le fractionnement vise en effet toujours à minimiser l'énergie de surface.

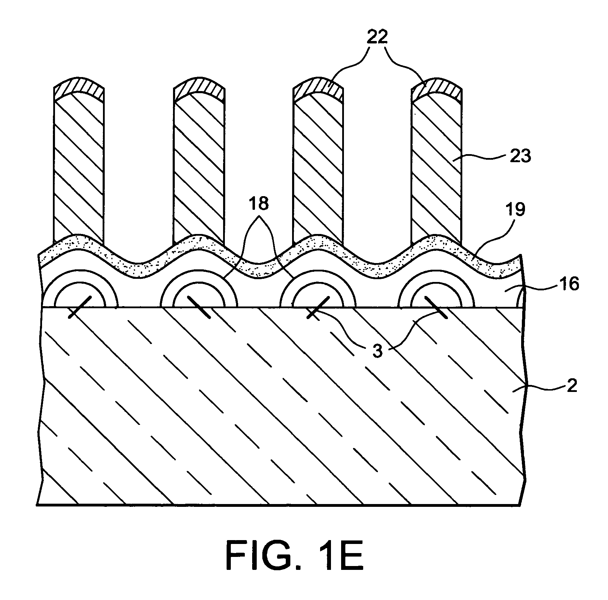

Sur les nanoparticules 22 de nickel, on peut faire croître, par exemple par CVD, des nanofils 23 de carbone, également appelés nanotubes de carbone. Pour cela, on place l'ensemble dans une atmosphère d'acétylène, et on procède à un recuit thermique à une température d'environ 600°C. On pourrait de façon analogue faire croître des nanofils de silicium dans une atmosphère de silane. Les nanotubes 23 de carbone croissent ainsi à l'endroit où se situent les nanoparticules 22 de nickel et la position, la densité et le diamètre des nanostructures 23 sont ainsi bien contrôlés (voir figure 1E).

Pour avoir une localisation et une densité de nanostructures de carbone différentes, on peut changer la désorientation entre le substrat et le film. Par exemple, comme précédemment, on colle par adhésion moléculaire les faces de deux substrats cristallins de silicium, les faces des deux substrats étant placées de manière à avoir une désorientation de 0,44° en rotation sans désorientation de flexion à l'interface de collage, ce qui permet d'obtenir une périodicité de 50 nm. On procède ensuite à l'amincissement d'un des substrats jusqu'à obtenir un film mince 16 et on traite ce film mince de manière à faire apparaître les champs de contraintes 18 à la surface du film (voir figure 1A). On peut ensuite réaliser éventuellement une gravure le long des champs de contrainte pour créer un relief ou une topographie à la surface du film 16 (voir figure 1B). On obtient ainsi une topographie de surface périodique corrélée avec le réseau de champs de contraintes 18 et le réseau de dislocations 3 présent à l'interface de collage. Ensuite, on oxyde la surface de silicium 16 pour former une couche d'oxyde 19 de 10 nm et on dépose, à basse température (par exemple à température ambiante) un film 20 de nickel de 5 nm d'épaisseur (voir figure 1C). On porte l'ensemble à plus haute température (par exemple à 550°C) pour que le film de nickel se fractionne (voir figure 1D). Enfin, on place l'ensemble dans une atmosphère d'acétylène et on fait croître des nanotubes 23 de carbones sur les nanoparticules 22 de nickel (voir figure 1E).

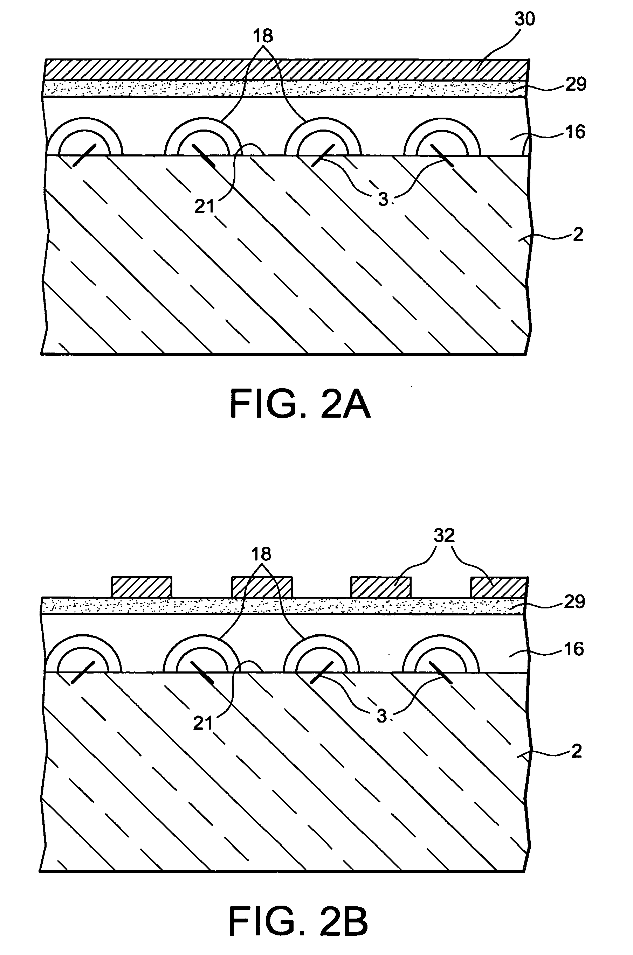

Nous pouvons également réaliser un support présentant des nanofils de silicium à partir de nanoparticules d'or. Comme dans les exemples précédents, on colle les faces de deux substrats cristallin de silicium, on amincit un des substrats pour obtenir un film mince 16 et on procède au traitement du film mince, par exemple par un traitement thermique, de manière à faire apparaître les champs de contraintes 18, présents à l'interface de collage, à la surface du film mince. Le film et le substrat présentent par exemple une désorientation de 0,88° en rotation sans désorientation de flexion, ce qui permet d'obtenir une périodicité de 25 nm. On oxyde la surface pour former une couche intermédiaire 29 d'oxyde de silicium de 5 nm à la surface du film mince et on dépose à basse température (par exemple à température ambiante) un film 30 d'or sur cette couche intermédiaire (voir figure 2A). Ici, comme la couche intermédiaire a une épaisseur de seulement 5 nm, cette épaisseur est suffisamment fine pour ne pas bloquer les champs de contraintes 18 : les champs de contraintes 18 peuvent se propager à la surface de la couche intermédiaire 29 (la propagation des champs de contraintes n'est pas représentée) et l'influence des défauts cristallins et/ou des champs de contraintes peut apparaître à la surface de la couche 29. Il n'ait donc pas nécessaire de procéder à une étape de gravure sélective le long des champs de contraintes.

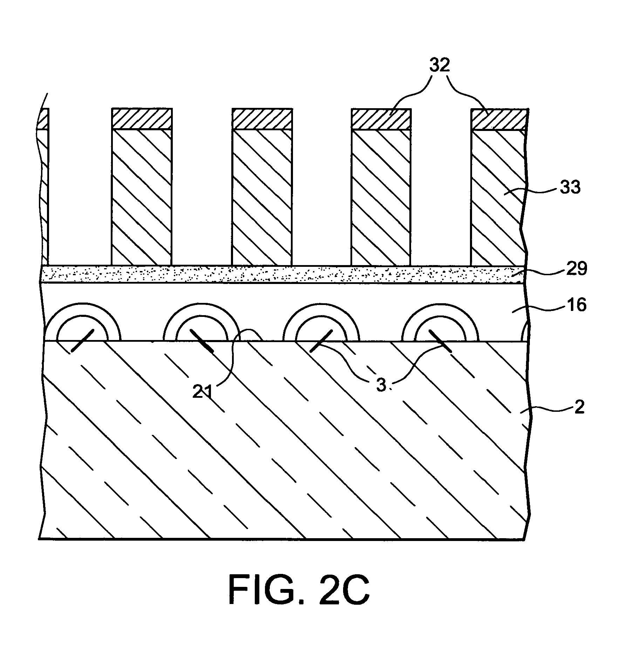

Ensuite, l'ensemble est porté à plus haute température (par exemple à 500°C) pour que le film 30 d'or se fractionne. Les gouttes 32 de métal (or) sont alors localisées par les champs de contrainte (voir figure 2B). Puis, on place l'ensemble dans une atmosphère de SiH₄ et on fait croître des nanofils 33 de silicium sur les nanoparticules d'or (voir figure 2C).

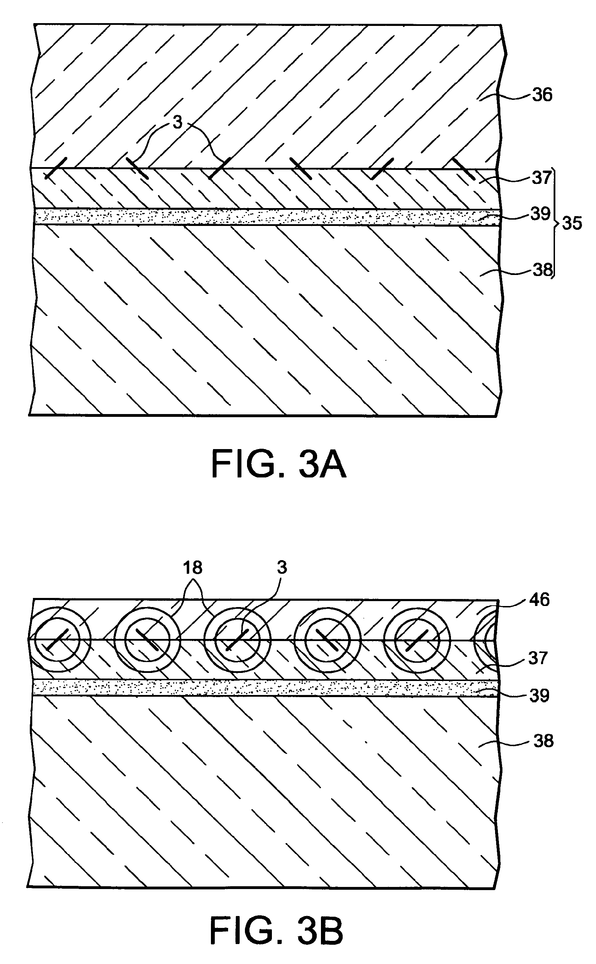

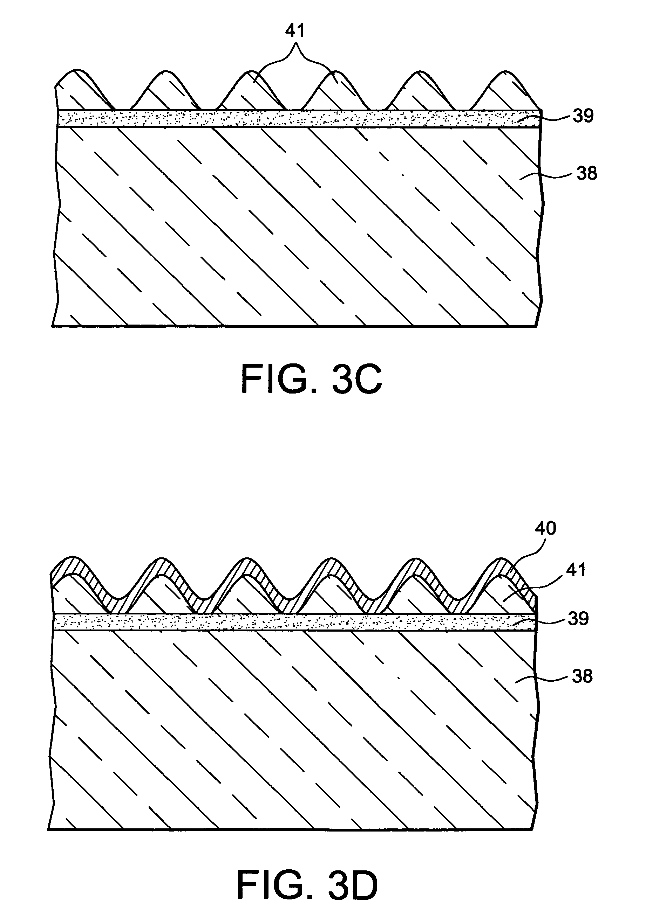

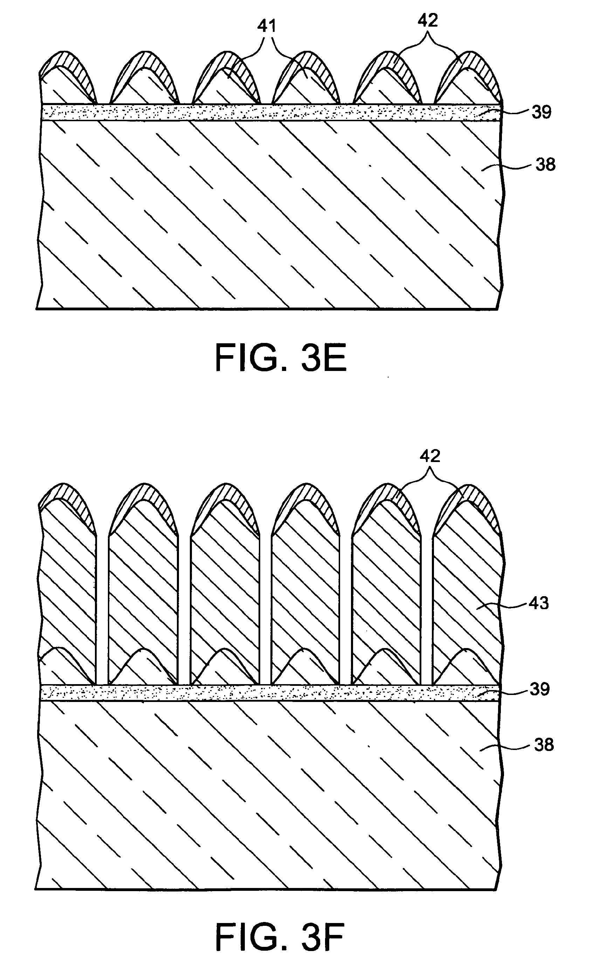

Selon un autre exemple de réalisation, on peut, pour faciliter le fractionnement de la couche de catalyseur, se placer sur une surface présentant non seulement une topographie de surface, mais aussi deux matériaux distincts. En effet lors de la formation de la topographie de surface par gravure sélective des champs de contraintes, on peut, si cette gravure débouche sur une couche d'un matériau différent, obtenir deux types de matériaux à la surface du substrat. La localisation des gouttes de métal lors du fractionnement du film métallique s'en trouve alors facilitée. Par exemple, on peut coller une structure « SOI » 35 (Silicium Sur Isolant en français) comprenant une couche 39 d'oxyde de silicium enterrée (la couche est située entre le substrat support 38 et une couche mince 37) avec une deuxième structure SOI ou avec un substrat de silicium 36 qu'il faudra amincir par la suite. La structure SOI 35 et le substrat 36 de silicium sont collés par adhésion moléculaire hydrophobe avec un angle de désorientation de 0,88° sans désorientation de flexion, ce qui crée un réseau de défauts cristallins et/ou de champs de contraintes (sur la figure 3A, on n'a représenté que les dislocations à l'interface de collage, symbolisés par la référence 3, afin de simplifier le dessin). On amincit le substrat 36 de silicium (ou la face arrière de la deuxième structure SOI) pour ne conserver qu'un film mince 46 de silicium (voir figure 3B). On grave ensuite sélectivement le long des champs de contrainte 18 du réseau de dislocations 3 présents à l'interface de collage et on poursuit la gravure (en changeant éventuellement de type de gravure) jusqu'à atteindre la couche 39 d'oxyde enterrée. On obtient ainsi un relief périodique formé de nanocristaux 41 de silicium sur une couche 39 d'oxyde de silicium (voir figure 3C). On dépose alors directement un film 40 d'or à basse température (par exemple à température ambiante) sur la face du support comprenant les nanocristaux 41 de silicium (voir figure 3D). Puis, on porte l'ensemble à haute température (500°C) afin de fractionner le film 40 de métal. Les gouttes 42 de métal se localisent alors sur les nanocristaux 41 de silicium (voir figure 3E). Le fait qu'il y ait de l'oxyde de silicium 39 entre les nanocristaux de silicium facilite le fractionnement de la couche d'or 40 et la localisation des gouttes 42 d'or sur les nanocristaux 41 de silicium, car l'affinité de l'or est différente avec le silicium et avec la silice : ici, la couche 39 enterrée du SOI sert de couche intermédiaire. On peut ensuite faire croître des nanostructures 43 de silicium du type nanofils sur les gouttes 42 d'or en plaçant l'ensemble dans une atmosphère de silane et en procédant à un recuit thermique, par exemple à 440°C, de l'ensemble (voir figure 3F).

En variante, il est possible pour obtenir une surface présentant non seulement une topographie de surface, mais aussi deux matériaux distincts et ainsi faciliter le fractionnement ultérieur, de procéder, avant le dépôt de la couche continue de catalyseur, au dépôt d'une couche intermédiaire sensible à la topographie et/ou au réseau de champs de contraintes et/ou de défauts cristallins sous-jacents. Cette couche ne sera alors présente que localement. A titre d'exemple, on pourra déposer du germanium sur une surface de silicium sur laquelle on aura révélé un réseau de champs de contraintes et/ou de défauts cristallins comme décrit précédemment : le germanium se localisera au niveau des zones en saillie de la surface de silicium. On pourra alors procéder au dépôt de la couche continue de catalyseur.

### BIBLIOGRAPHIE

**[1]** Yi Cui, Lincoln J. Lauhon, Mark S. Gudiksen, Jianfang Wang, and Charles M. Lieber, Applied Physics Letters Volume 78, Number 15, 9 Avril 2001, 2214.
**[2]** WO 2004/000728 A
**[3]** Demande de brevet FR2815121-A1.
**[4]** Demande de brevet FR2766620-A1.
**[5]** WO 02/29131 A

## Revendications

1. Procédé de réalisation d'un support comprenant des nanoparticules (22, 32, 42) pour la croissance de nanostructures (23, 33, 43), lesdites nanoparticules étant organisées de manière périodique, le procédé étant **caractérisé en ce qu'**il comporte les étapes suivantes :
- fourniture d'un support comportant au voisinage d'une de ses faces un réseau périodique de défauts cristallins et/ou de champs de contraintes (18),
- dépôt sur ladite face d'une couche continue (20, 30, 40) d'un premier matériau apte à catalyser la réaction de croissance des nanostructures,
- fractionnement de la couche de premier matériau (20, 30, 40) par traitement thermique de manière à former les nanoparticules (22, 32, 42) de premier matériau.

2. Procédé de réalisation selon la revendication 1, dans lequel la période du réseau de défauts cristallins et/ou de champs de contraintes est choisi en fonction de la période naturelle d'auto-organisation qu'auraient eu les nanoparticules (22, 32, 42) sur un substrat ne présentant pas ce réseau de défauts cristallins et/ou de champs de contraintes, avec l'épaisseur de couche continue (20, 30, 40) utilisée avant le fractionnement.

3. Procédé de réalisation selon la revendication 1, dans lequel l'étape de fourniture du support est obtenue en effectuant les étapes suivantes :
- collage par adhésion moléculaire d'une face (14) d'un premier substrat en matériau cristallin avec une face (21) d'un deuxième substrat (2) en matériau cristallin, de façon à ce que lesdites faces présentent des réseaux cristallins décalés, le collage provoquant la formation d'un réseau de défauts cristallins et/ou de champs de contraintes (18) au voisinage de l'interface de collage,
- amincissement de l'un (1) des substrats jusqu'à obtenir un film mince (16) adhérant à l'autre substrat (2) selon l'interface de collage (14/21), l'épaisseur du film mince (16) étant telle que sa face libre révèle la présence du réseau de défauts cristallins et/ou de champs de contraintes.

4. Procédé de réalisation selon la revendication 1, dans lequel l'étape de fourniture du support est obtenue en effectuant les étapes suivantes :
- collage par adhésion moléculaire d'une face (14) d'un premier substrat en matériau cristallin avec une face (21) d'un deuxième substrat (2) en matériau cristallin, de façon que lesdites faces présentent des réseaux cristallins décalés, le collage provoquant la formation d'un réseau de champs de contraintes et/ ou de défauts cristallins (18) au voisinage de l'interface de collage,
- amincissement de l'un (1) des substrats jusqu'à obtenir un film mince (16) adhérant à l'autre substrat (2) selon l'interface de collage (14/21), l'épaisseur du film mince (16) étant telle que sa face libre (15) ne révèle pas la présence du réseau de champs de contraintes et/ ou de défauts cristallins (18), l'épaisseur du film mince (16) étant aussi telle que l'étape suivante peut être réalisée,
- traitement du film mince (16) conduisant à ce que sa face libre révèle la présence du réseau de défauts cristallins et/ou de champs de contraintes (18).

5. Procédé de réalisation selon la revendication 4, dans lequel le traitement du film mince (16) est choisi parmi un traitement thermique et/ou une attaque mécanique et/ou une attaque chimique et/ou une attaque électrochimique et/ou une attaque ionique et/ou une attaque photochimique.

6. Procédé de réalisation selon la revendication 1, dans lequel l'étape de fourniture du support est obtenue par report d'un film mince présentant un réseau de défauts cristallins et/ou de champs de contraintes au voisinage de sa future face libre sur un substrat.

7. Procédé de réalisation selon l'une quelconque des revendications 3, 4 ou 6, comprenant en outre une étape de gravure sélective de la face libre du film mince par des moyens de gravure préférentielle des défauts cristallins et/ou des champs de contraintes (18) ou des zones situées entre ces défauts et/ou ces champs (18), de manière à obtenir une topographie de surface périodique sur la face du support.

8. Procédé de réalisation selon l'une quelconque des revendications 3 ou 4, dans lequel le premier substrat et le deuxième substrat (2) sont en un même matériau cristallin.

9. Procédé de réalisation selon l'une quelconque des revendications 3 ou 4, dans lequel le premier substrat et/ou le deuxième substrat (2) sont en Si, Ge, SiC, GaN, GaAs, InP.

10. Procédé de réalisation selon l'une quelconque des revendications précédentes, dans lequel le premier matériau comprend au moins un métal choisi parmi Ni, Au, W, Pt.

11. Procédé de réalisation selon l'une quelconque des revendications précédentes, comprenant en outre une étape de formation d'une couche intermédiaire en un second matériau sur la face du support.

12. Procédé de réalisation selon la revendication 11, dans lequel la couche intermédiaire est discontinue et localisée en fonction du réseau périodique de défauts cristallins et/ou de champs de contraintes.

13. Procédé de réalisation selon la revendication 11, dans lequel la couche intermédiaire comprend un matériau choisi parmi SiO₂, Si₃N₄, Al₂O₃, le diamant, HfO₂ ou un matériau semiconducteur.

14. Procédé de réalisation selon la revendication 7, dans lequel le substrat sur lequel le film mince adhère est un empilement (35) comprenant une couche (39) d'un troisième matériau située entre un autre film mince (37) de matériau cristallin et un substrat (38), la face de collage dudit substrat étant la face libre de cet autre film mince (37).

15. Procédé de réalisation selon la revendication 14, dans lequel l'empilement (35) est un substrat silicium sur isolant (SSI ou SOI en anglais) comprenant une couche d'isolant entre un film mince de silicium et un substrat de silicium.

16. Procédé de réalisation selon la revendication 14, dans lequel la gravure sélective est réalisée jusqu'à atteindre la couche (39) de troisième matériau de l'empilement.

17. Procédé de réalisation de nanostructures sur des nanoparticules localisées sur une face d'un support, ledit procédé comprenant la mise en oeuvre du procédé de réalisation du support selon l'une quelconque des revendications 1 à 16, puis une étape de croissance des nanostructures (23, 33, 43) sur les nanoparticules (22, 32, 42) de premier matériau.

## Claims

1. Method for producing a support comprising nanoparticles (22, 32, 4%) for the growth of nanostructures, (23, 33, 43), said nanoparticles being organized periodically, the method being **characterised in that** it comprises the following steps:
- providing a support comprising, in the vicinity of one of its surfaces, a periodic array of crystal defects and/or stress fields (18),
- depositing, on said surface, a continuous layer (20, 30, 40) of a first material capable of catalysing the nanostructure growth reaction,
- fractionating the first material layer (20, 30, 40) by a heat treatment so as to form the first: material nanoparticles (22, 32, 42).

2. Method of production according to claim 1, **characterised in that** the period of the array of crystal defects and/or stress fields is chosen according to the natural self-organisation period that the nanoparticles (22, 32, 42) would have on a substrate without this array of crystal defects and/or stress fields, with the thickness of the continuous layer (20, 30, 40) used before the fractionation.

3. Method of production according to claim 1, **characterised in that** the step of providing the support is achieved by carrying out the following steps:
- bonding by molecular adhesion of a surface (14) of a first substrate made of a crystalline material with a surface (21) of a second substrate (2) made of a crystalline material, so that said surfaces have offset crystal lattices, the bonding causing the formation of an array of crystal defects and/or stress fields (18) in the vicinity of the bonding interface,
- thinning of one (1) of the substrates until obtaining a thin film (16) adhering to the other substrate (2) according to the bonding interface (14/21), the thickness of the thin film (16) being such that its free surface reveals the presence of the array of crystal defects and/or stress fields.

4. Method of production according to claim 1, **characterised in that** the step of providing the support is achieved by carrying out the following steps:
- bonding by molecular adhesion of a surface (14) of a first substrate made of a crystalline material with a surface (21) of a second substrate (2) made of a crystalline material, so that said surfaces have offset crystal lattices, the bonding causing the formation of an array of stress fields and/or crystal defects (18) in the vicinity of the bonding interface,
- thinning of one (1) of the substrates until obtaining a thin film (16) adhering to the other substrate (2) according to the bonding interface (14/21), the thickness of the thin film (16) being such that its free surface (15) does not reveal the presence of the array of stress fields and/or crystal defects (18), the thickness of the thin film (16) also being such that the following step can be carried out,
- treating the thin film (16), causing its free surface to reveal the presence of the array of crystal defects and/or stress fields (18).

5. Method of production according to claim 4, **characterised in that** the treatment of the thin film (16) is chosen from a heat treatment and/or a mechanical attack and/or a chemical attack and/or an electrochemical attack and/or an ion attack and/or a photochemical attack.

6. Method of production according to claim 1, **characterised in that** the step of providing the support is achieved by transferring a thin film on a substrate, said thin film having an array of crystal defects and/or stress fields in the vicinity of its future free surface.

7. Method of production according to any one of claims 3, 4 or 6, **characterised in that** it also includes a step of selective etching of the free surface of the thin film by means of preferential etching of crystal defects and/or stress fields (18) or areas located between these defects and/or these fields (18), so as to obtain a periodic surface topography on the surface of the support.

8. Method of production according to either one of claims 3 or 4, **characterised in that** the first substrate and the second substrate (2) are made of the same crystalline material.

9. Method of production according to either one of claims 3 or 4, **characterised in that** the first substrate and/or the second substrate (2) are preferably made of Si, Ge, SiC, GaN, GaAs or Ins.

10. Method of production according to any one of the previous claims, **characterised in that** the first material includes at least one metal chosen from Ni, Au, W and Pt.

11. Method of production according to any one of the previous claims, **characterised in that** it also includes a step of forming an intermediate layer made of a second material on the surface of the support.

12. Method of production according to claim 11, **characterised in that** the intermediate layer is discontinuous and localised according to the periodic array of crystal defects and/or stress fields.

13. Method of production according to claim 11, **characterised in that** the intermediate layer includes a Material chosen from SiO₂, Si₃N₄, Al₂O₃, diamond, HfO₂ or a semiconductor material.

14. Method of production according to claim 7, **characterised in that** the substrate to which the thin film adheres is a stack (35) comprising a layer (39) of a third material located between another thin film (37) of crystalline material and a substrate (38), the bonding surface of said substrate being the free surface of said other thin film (37).

15. Method of production according to claim 14, **characterised in that** the stack (35) is a silicon-on-insulator substrate (SOI) comprising an insulating layer between a thin film of silicon and a silicon substrate.

16. Method of production according to claim 14, **characterised in that** the selective etching is performed until reaching the layer (39) of third material of the stack.

17. Method for producing nanostructures on nanoparticles localized on a surface of a support, said method being **characterised in that** it includes the implementation of the method for producing the support according to any one of claims 1 to 16, followed by a step of growing nanostructures (23, 33, 43) on the first material nanoparticles (22, 32, 42).

## Patentansprüche

1. Verfahren zur Herstellung eines Trägers, der Nanopartikel (22, 32, 42) für das Wachstum von Nanostrukturen (23, 33, 43) umfasst, wobei die genannten Nanopartikel periodisch angeordnet sind und das Verfahren **dadurch gekennzeichnet ist, dass** es die folgenden Schritte umfasst:
Realisierung eines Trägers mit einem periodischen Gitter von Kristallfehlern und/oder Spannungsfeldern (18) in der Nähe einer seiner Flächen,
- Abscheidung, auf der genannten Fläche, einer durchgehenden Schicht (20, 30, 40) aus einem ersten Material, fähig die Wachstumsreaktion der Nanostrukturen zu katalysieren,
- Fraktionierung der Schicht aus dem ersten Material (20, 30, 40) durch thermische Behandlung, um die Nanopartikel (22, 32, 42) zu bildern.

2. Herstellungsverfahren nach Anspruch 1, bei dem die Periode des Kristallfehler- und/oder Spannungsfelder-Gitters gewählt wird in Abhängigkeit von der natürlichen Selbstorganisationsperiode der Nanopartikel (22, 32, 42) auf einem Substrat ohne dieses Kristallfehler- und/oder Spannungsfelder-Gitter, mit der vor der Fraktionierung benutzten Dicke der durchgehenden Schicht (20, 30, 40).

3. Herstellungsverfahren nach Anspruch 1, bei dem der Trägerrealisierungsschritt die folgenden Schritte umfasst:
- Verklebung, durch molekulare Adhäsion, einer Fläche (14) eines ersten Substrats aus kristallinem Material mit einer Fläche (21) eines zweiten Substrats (2) aus kristallinem Material, so dass die genannten Flächen zueinander versetzte Kristallgitter aufweisen, wobei die Verklebung die Bildung eines Gitters von Kristallfehlern und/oder Spannungsfeldern (18) in der Nähe der Klebungsschnittstelle verursacht,
- Dünnung eines (1) der Substrate, bis es einen mittels der Klebungsschnittstelle (14/21) an dem anderen Substrat (2) haftenden dünnen Film (16) bildet, wobei die Dicke des dünnen Films (16) so ist, dass seine freie Fläche die Präsenz des Kristallfehler- und/oder Spannungsfelder-Gitters offenbart.

4. Herstellungsverfahren nach Anspruch 1, bei dem der Trägerrealisierungsschritt die folgenden Schritte umfasst:
- Verklebung, durch molekulare Adhäsion, einer Fläche (14) eines ersten Substrats aus kristallinem Material mit einer Fläche (21) eines zweiten Substrats (2) aus kristallinem Material, so dass die genannten Flächen zueinander versetzte Kristallgitter aufweisen, wobei die Verklebung die Bildung eines Gitters von Spannungsfeldern und/oder Kristallfehlern (18) in der Nähe der Klebungsschnittstelle verursacht,
- Dünnung eines (1) der Substrate, bis es einen gemäß der Klebungsschnittstelle (14/21) an dem anderen Substrat (2) haftenden dünnen Film (16) bildet, wobei die Dicke des dünnen Films (16) so ist, dass seine freie Fläche (15) die Präsenz des Kristallfehler- und/oder Spannungsfelder-Gitters nicht offenbart, wobei die Dicke des dünnen Films (16) auch so ist, dass der nächste Schritt realisiert werden kann,
- Behandlung des dünnen Films (16), dazu führend, dass seine freie Fläche die Präsenz des Kristallfehler- und/oder Spannungsfelder-Gitters (18) offenbart.

5. Herstellungsverfahren nach Anspruch 4, bei dem die Behandlung des dünnen Films (16) ausgewählt wird unter einer thermischen Behandlung und/oder einer mechanischen Bearbeitung und/oder einem chemischen Angriff und/oder einem elektrochemischen Angriff und/oder einem Ionenangriff und/oder einem fotochemischen Angriff.

6. Herstellungsverfahren nach Anspruch 1, bei dem der Trägerrealisierungsschritt darin besteht, einen dünnen Film - mit einem Kristallfehler- und/oder Spannungsfelder-Gitter in der Nähe seiner künftigen freien Fläche - auf ein Substrat zu übertragen.

7. Herstellungsverfahren nach einem der Ansprüche 3, 4 oder 6 mit außerdem einem Schritt des selektiven Ätzens der freien Fläche des dünnen Films durch Mittel, die vorzugsweise Kristallfehler und/oder Spannungsfelder (18) oder sich zwischen diesen Kristallfehlern und/oder Spannungsfeldern (18) befindliche Zonen ätzen, um auf der Fläche des Trägers eine periodische Oberflächentopographie zu realisieren.

8. Herstellungsverfahren nach einem der Ansprüche 3 oder 4, bei dem das erste Substrat und das zweite Substrat (2) aus einem selben kristallinen Material sind.

9. Herstellungsverfahren nach einem der Ansprüche 3 oder 4, bei dem das erste Substrat und/oder das zweite Substrat (2) aus Si, Ge, SiC, GaN, GaAs, InP sind.

10. Herstellungsverfahren nach einem der vorangehenden Ansprüche, bei dem das erste Material wenigstens ein unter Ni, Au, W, Pt ausgewähltes Material umfasst.

11. Herstellungsverfahren nach einem der vorangehenden Ansprüche, das außerdem einen Schritt zur Bildung einer Zwischenschicht aus einem zweiten Material auf der Fläche des Trägers umfasst.

12. Herstellungsverfahren nach Anspruch 11, bei dem die Zwischenschicht unterbrochen ist und in Abhängigkeit von dem periodischen Kristallfehler- und/oder Spannungsfelder-Gitter lokalisiert ist.

13. Herstellungsverfahren nach Anspruch 11, bei dem die Zwischenschicht ein unter SiO₂, Si₃N₄, Al₂O₃, Diamant, HfO₂ oder einem Halbleitermaterial ausgewähltes Material umfasst.

14. Herstellungsverfahren nach Anspruch 7, bei dem das Substrat, auf dem der dünne Film haftet, ein Stapel (35) ist, mit einer Schicht (39) aus einem dritten Material, zwischen einem anderen dünnen Film (37) aus kristallinem Material und einem Substrat (38), wobei die Klebungsfläche des genannten Substrats die freie Seite dieses anderen dünnen Films (37) ist.

15. Herstellungsverfahren nach Anspruch 14, bei dem der Stapel (35) ein SOI-Substrat ist, mit einer Isolierschicht zwischen einem dünnen Siliciumfilm und einem Siliciumsubstrat.

16. Herstellungsverfahren nach Anspruch 14, bei dem das selektive Ätzen solange erfolgt, bis die Schicht (39) aus dem dritten Stapelmaterials erreicht ist.

17. Herstellungsverfahren von Nanostrukturen auf Nanopartikeln, lokalisiert auf einer Fläche eines Trägers, wobei das Verfahren die Anwendung des Herstellungsverfahrens des Trägers nach einem der Ansprüche 1 bis 16 und dann einen Wachstumsschritt der Nanostrukturen (23, 33, 43) auf den Nanopartikeln (22, 32, 42) aus dem ersten Material umfasst.
